# EUROPÄISCHE PATENTSCHRIFT

(11) **EP 0 582 252 B1**
(45) Veröffentlichungstag und Bekanntmachung des Hinweises auf die Patenterteilung: **25.03.1998**
(21) Anmeldenummer: 93112357.4
(22) Anmeldetag: 02.08.1993
(51) Int. Cl.: G03F 7/20

(54) **Vorbelichtungseinrichtung für bildmässig zu belichtende Druckformen**
Pre-exposure device for photosensitive printing elements
Equipement pour la préexposition d'éléments d'impression photosensibles

(30) Priorität: 05.08.1992 DE 4225829
(43) Veröffentlichungstag der Anmeldung: 09.02.1994
(73) Patentinhaber: Agfa-Gevaert AG, 51373 Leverkusen (DE)
(72) Erfinder: Zertani, Rudolf Dr., D-55130 Mainz (DE); Krämer, Norbert, 65321 Heidenrod (DE); Haberhauer, Helmuth, 65232 Taunusstein (DE)

(56) Entgegenhaltungen:
- DE-U- 9 210 461
- US-A- 4 716 097
- PATENT ABSTRACTS OF JAPAN vol. 12, no. 274 (M-725) 29. Juli 1988 & JP-A-63 057 262 (FUJI XEROX CO LTD) 11. März 1988

## Beschreibung

Die Erfindung betrifft eine Vorbelichtungseinrichtung für bildmäßig zu belichtende Druckformen, mit einem nach unten hin durch eine Scheibe abgeschlossenen Gehäuse, in dem eine Strahlungsquelle angeordnet ist.

Aus der DE-B 12 14 085 (US-PS 3,144,331) ist es bekannt, zur Wiederherstellung der Empfindlichkeit fotopolymerisierbare Aufzeichnungsmaterialien, die als lichtempfindliche Schicht auf einem Druckplattenträger aufgetragen sind und deren Empfindlichkeit durch Absorption von molekularem Sauerstoff nachgelassen hat, mit 70 bis 98 % der Strahlungsmenge einer aktinischen Strahlung zu belichten, die bei gleichmäßigem Auftreffen zur Einleitung einer Fotopolymerisation notwendig wäre. Die Belichtung erfolgt durch den beispielsweise transparenten Druckplattenträger hindurch, wobei eine aktinische Strahlung mit einer solchen Wellenlänge verwendet wird, daß nur 10 bis 70 % der Strahlung von der fotopolymerisierbaren Schicht absorbiert werden. Bei diesem Verfahren wird im Prinzip einmal diffus und einmal bildmäßig belichtet. Die Diffus- bzw. Vorbelichtung erfolgt mit geringerer Intensität, nämlich mit 70 bis 98 % der Strahlungsintensität, die zum Erreichen der vollen Belichtungswirkung erforderlich ist. An diese Vorbelichtung schließt dann die bildmäßige Belichtung mit voller Strahlungsintensität an.

In der US-PS 4,298,803 ist ein Verfahren beschrieben, bei dem eine Fotoresistschicht mit einer Intensität vorbelichtet wird, die niedriger als die kritische Belichtungsintensität ist, bei der der Fotoresist an den belichteten Stellen weitgehend weggelöst werden kann. Nach dieser Vorbelichtung erfolgt die bildmäßige Belichtung der Fotoresistschicht. Die Reihenfolge der beiden Belichtungen kann vertauscht werden. In beiden Fällen wird die Lichtempfindlichkeit der Fotoresistschicht verbessert, wodurch die Bearbeitungszeit stark verkürzt wird. Bei der für dieses Verfahren eingesetzten Vorrichtung können sowohl die bildmäßige Belichtung als auch die Vor- bzw. Nachbelichtung des Fotoresists mittels eines Elektronenstrahls, einer UV- oder Röntgenstrahlenquelle erfolgen.

Aus der US-PS 4,716,097 ist gleichfalls ein Verfahren bekannt, bei dem eine fotopolymere Schicht, die einen Farbstoff enthält, zuerst mit Licht einer Wellenlänge oberhalb von 400 nm und einer Intensität von mindestens 1500 Lumen/m² diffus und danach bildmäßig belichtet wird.

In der deutschen Offenlegungsschrift DE-A 24 12 571 ist ein Verfahren zum Aushärten einer durch Licht härtbaren Polymerschicht einer Druckplatte beschrieben, bei dem zuerst diffus für kurze Zeit belichtet und danach bildmäßig so lange belichtet wird, bis die Polymerschicht praktisch vollständig in den belichteten Bereichen ausgehärtet ist. Die diffuse Belichtungsdauer beträgt maximal 90 % der Zeit, innerhalb welcher die vollständige Aushärtung der Polymerschicht bei gleicher Intensität der Strahlung sowohl für die Vorbelichtung als auch für die bildmäßige Belichtung erfolgt.

Aufgabe der Erfindung ist es, eine Vorbelichtungseinrichtung für bildmäßig zu belichtende Druckformen so zu entwickeln, daß eine spektrale Veränderung der Strahlungsquelle der Vorbelichtungseinrichtung durch Alterung nicht auftritt und eine gleichmäßige Leuchtstärke über die volle Länge des jeweiligen Belichtungsabschnitts der Druckformen einstellbar ist.

Diese Aufgabe wird erfindungsgemäß in der Weise durch eine Vorbelichtungseinrichtung der eingangs beschriebenen Art gelöst, daß die Strahlungsquelle eine LED-Zeilenanordnung aus zumindest zwei Reihen von Modulen aus Leuchtdioden ist, daß die LED-Zeilenanordnung die unterhalb der Vorbelichtungseinrichtung vorbeibewegten Druckformen ganzflächig vorbelichtet, daß die Scheibe eine die LED-Zeilenanordnung nach unten hin abdeckende Lichtstreuscheibe ist und daß die LED-Zeilenanordnung in einem Leuchtstärke- bzw. Leuchtleistungsbereich von 0 bis 100 % regelbar ist.

In Ausgestaltung der Erfindung strahlt die LED-Zeilenanordnung eine Strahlung für die Vorbelichtung der Druckformen in einem Wellenlängenbereich von 565 ± 20 nm ab.

Die weitere Ausgestaltung der Erfindung ergibt sich aus den Merkmalen der Patentansprüche 3 bis 11.

Mit der Vorbelichtungseinrichtung nach der Erfindung werden fotopolymerbeschichtete Druckformen, insbesondere Projektionsplatten und hoch-lichtempfindliche Laserplatten belichtet, wobei durch die Vorbelichtung mit Licht sehr geringer und sehr gleichmäßiger Intensität die Lichtempfindlichkeit der so behandelten Druckformen erheblich gesteigert werden kann. Hierzu werden die unbelichteten Druckformen, die beispielsweise nach erfolgter Vorbelichtung in einem Laserbelichtungsgerät mit einer Wellenlänge von 488 nm belichtet werden oder einer Projektionsbelichtung durch einen Quecksilber- oder Xenon-Strahler, Blitzlicht, Kohlenstofflampe oder dergleichen ausgesetzt werden, in der Vorbelichtungseinrichtung mit Licht einer Wellenlänge λ = 565 ± 20 nm mit sehr geringer Intensität vorbelichtet. Von Vorteil ist bei dieser Vorbelichtungseinrichtung, daß die Leuchtstärke der Strahlungsquelle in sehr weiten Grenzen einstellbar ist.

Die Erfindung wird im folgenden anhand der Zeichnung näher erläutert. Es zeigen:
- Fig. 1: eine schematische Schnittansicht der belichtungseinrichtung gemäß der Erfindung, und
- Figuren 2-4: eine Seitenansicht und Draufsicht sowie die Schaltung einer LED-Zeilenanordnung der Vorbelichtungseinrichtung.

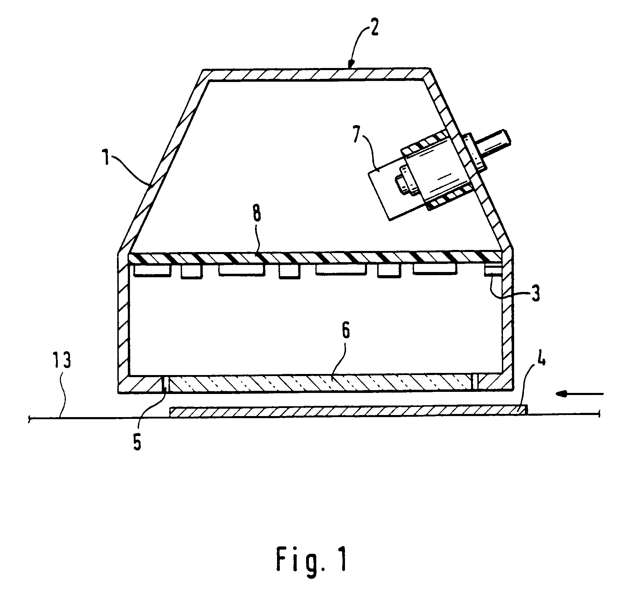

Die in Fig. 1 im Schnitt schematisch dargestellte Vorbelichtungseinrichtung 2 weist ein Gehäuse 1 auf, das nach unten hin durch eine Scheibe abgeschlossen ist, bei der es sich um eine Lichtstreuscheibe 6 handelt, die in einer Gehäuseöffnung 5 der Gehäuseunterseite angebracht ist. Druckformen 4, von denen eine in Fig. 1 schematisch gezeigt ist, laufen entlang einer Transportbahn 13 in Pfeilrichtung an der Vorbelichtungseinrichtung 2 und unterhalb von dieser vorbei. Im Gehäuse 1 ist eine elektronische Regelung 7 für eine Strahlungsquelle in Gestalt einer LED-Zeilenanordnung 8 untergebracht. Die Leuchtstärke der Strahlungsquelle mißt ein Sensor 3, der auf der Abstrahlseite der LED-Zeilenanordnung befestigt ist.

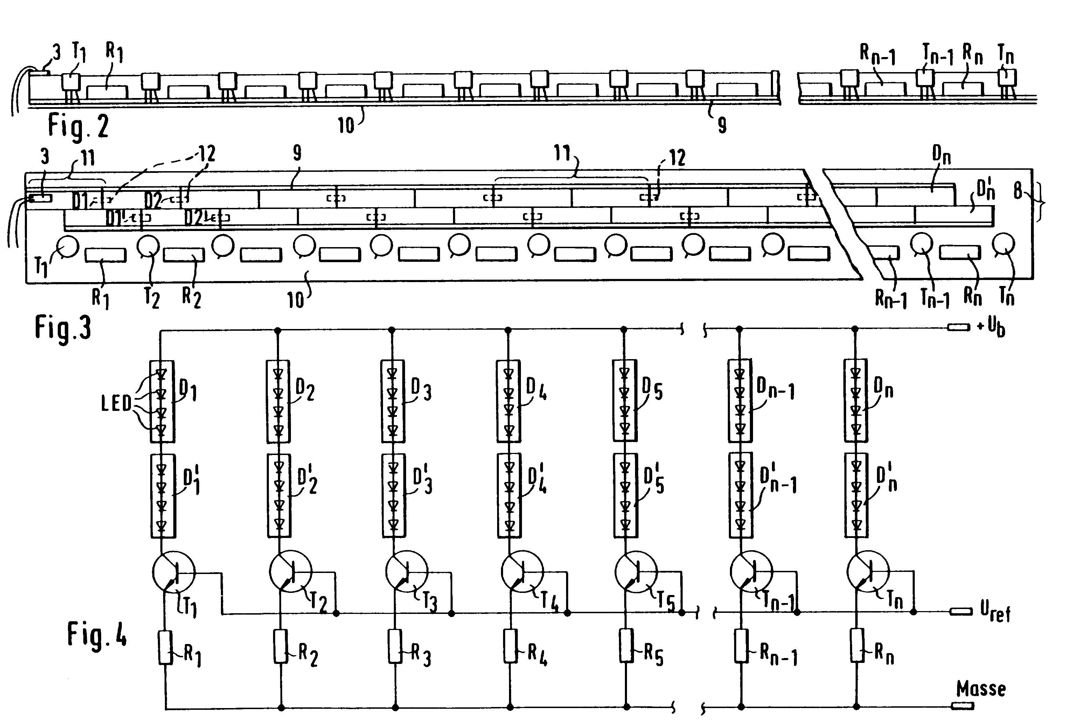

Die LED-Zeilenanordnung 8 dient zusammen mit der Lichtstreuscheibe der ganzflächigen, diffusen Belichtung der Druckform 4. Diese LED-Zeilenanordnung 8 besteht zumindest aus zwei zueinander versetzten Reihen von LED-Modulen D₁, D₂, ... Dₙ und D₁', D₂' ... Dₙ', wie die Figuren 2 und 3 zeigen, und befindet sich in einem geschlossenen Gehäuse 1 der Vorbelichtungseinrichtung 2. Nach unten hin, in Richtung der Transportbahn 13 für die Druckformen, weist das Gehäuse 1 eine Belichtungsöffnung 5 auf, die von einer Lichtstreuscheibe 6 abgedeckt ist.

Das einzelne Modul D₁, ... Dₙ, D₁' ... Dₙ' besteht im allgemeinen aus vier Leuchtdioden LED, die, wie in Figur 4 gezeigt, in Reihe geschaltet sind. Zwei Module D₁, D₁'; D₂, D₂' ... Dₙ, Dₙ' sind jeweils in Reihe geschaltet und werden von einer nicht dargestellten Stromquelle mit einer Referenzspannung U_{ref} gespeist. Je zwei in Reihe geschaltete Module werden von einem Stromkreis aus Transistor Tᵢ und strombegrenzendem Widerstand Rᵢ, mit i = 1, 2, ... n, gesteuert. Der Widerstand Rᵢ kann ein Festwiderstand oder ein regelbarer Widerstand in Gestalt eines Potentiometers sein. Die Stromquelle beaufschlagt die Basen sämtlicher Transistoren Tᵢ, die parallel geschaltet sind, mit der Referenzspannung U_{ref}. Die gleichfalls parallel geschalteten Widerstände Rᵢ begrenzen die Emitterströme der Transistoren Tᵢ. Die Referenzspannung U_{ref} ist eine Gleichspannung im Bereich von 0 bis 3 V, es fließt dann ein Basis-Emitterstrom I_{BE} von 0 bis 30 mA, oder eine Rechteckspannung im Bereich von 0 bis 6 V, mit einem Basis-Emitterstrom I_{BE} von 0 bis 60 mA, mit einem Tastverhältnis von 1:2. Die Stromquelle der Referenzspannung U_{ref} liefert einen Strom in der Größenordnung von 100 mA und kann z.B. ein D/A-Wandler mit einer Pufferstufe oder eine separate Steuerschaltung sein.

Die effektive Leuchtstärke der LED-Zeilenanordnung 8 wird durch den Sensor 3 gemessen. Damit eine gleichmäßige Ausleuchtung über die gesamte Breite der LED-Zeilenanordnung 8 erhalten wird, werden LED-Module aus einer Fertigung verwendet. Treten dennoch Helligkeitsunterschiede zwischen den einzelnen Modulen auf, so werden sie durch Verändern des zugehörigen Widerstandes Rᵢ ausgeglichen.

Die LED-Module D₁, D₁', ... Dₙ, Dₙ' sind auf Segmenten 11 angeordnet, die gleiche oder unterschiedliche Längen haben und werden mittels Steckkontakten 12 zu einer Platine 9, wie aus Fig. 3 ersichtlich, zusammengesteckt. Auf dem einzelnen Segment 11 kann ein einzelnes oder zwei bis vier Module angebracht sein. Die Steckkontakte 12 sind in Fig. 3 gestrichelt angedeutet. Je ein Segment 11 mit einem und mit zwei Modulen der oberen Reihe der LED-Zeilenanordnung 8 ist durch eine geschwungene Klammer markiert. Die zusammengesteckte Platine 9 ist auf einer Grundplatine 10 befestigt, auf der auch die Transistoren Tᵢ und Widerstände Rᵢ angeordnet sind. Da die einzelnen Segmente 11 unterschiedliche Längen haben können, ist die Reihenlänge an die Breite der zu belichtenden Druckform anpaßbar. Durch die segmentierte Bauweise der LED-Zeilenanordnung 8 ist bei einem Ausfall von einem oder mehreren LED-Modulen ein schneller Austausch möglich, da die funktionierenden Bauteile nicht ausgebaut werden müssen. Bei der Alterung der LED tritt keine spektrale Veränderung, d.h. keine Verschiebung des ausgesandten Wellenlängenbereiches auf. Durch die Stromregelung der LED-Module ist eine gleichmäßige Leuchtleistung über die volle Länge der LED-Zeilenanordnung 8 einstellbar, die mit Niederspannung betrieben wird.

Die Beleuchtungsstärke der LED-Zeilenanordnung 8 der Vorbelichtungseinrichtung 2 ist zur genauen Dosierung der auf die Druckform 4 applizierten Lichtmenge elektronisch stufenlos zwischen 0 % und 100 % der maximalen Beleuchtungsstärke regelbar. Die Anzeige der Beleuchtungsstärke dieser LED-Zeilenanordnung 8 erfolgt digital, wobei zur Messung der Beleuchtungsstärke der Sensor 3 im Inneren des Gehäuses angebracht ist. Die Geschlossenheit des Gehäuses verhindert das Auftreten von äußeren Störstrahlungen, die die Messung der Beleuchtungsstärke mittels des Sensors 3 in unerwünschter Weise beeinträchtigen könnten.

Die Einstellung der Beleuchtungsstärke der LED-Zeilenanordnung 8 erfolgt durch die elektronische Regelung 7, die oberhalb der LED-Zeilenanordnung 8 schematisch dargestellt ist.

Die spektrale Verteilung der LED-Zeilenanordnung 8 liegt im Wellenlängenbereich von 565 ± 20 nm.

Der Sensor 3 zur Messung der Beleuchtungsstärke ist üblicherweise eine Fotodiode, die sich im Gehäuse 1 der Vorbelichtungseinrichtung 2 befindet und dadurch von jeglicher Störstrahlung, wie beispielsweise in das Gehäuse 1 einfallendes Tageslicht, abgeschirmt ist. Zweckmäßigerweise ist die Fotodiode oberhalb der Platine 9 angebracht (vgl. Fig. 2).

Mit der Vorbelichtungseinrichtung 2 werden die Vorteile erzielt, daß die LED-Zeilenanordnung 8 über die Arbeitsbreite der Druckform 4 eine sehr gleichmäßige Belichtungsstärke erzeugt, und die Belichtungsintensität der LED-Module bzw. der LED-Zeilenanordnung 8 stufenlos geregelt werden kann. Die Ergebnisse der Belichtung für unterschiedliche Belichtungsintensitäten sind stets reproduzierbar. Eine Alterung der LED-Module verursacht keine spektrale Verschiebung, so daß die ausgesandte Wellenlänge weitgehend konstant bleibt. Weitere Vorteile der Vorbelichtungseinrichtung 2 bestehen darin, daß keine Störstrahlungen im Bereich der Vorbelichtungseinrichtung auftreten können, daß die LED-Zeilenanordnung 8 in ihrer Länge beliebig konfigurierbar ist und in ihrer vollen Länge zum Belichten genutzt werden kann und daß sie mit Niederspannung betrieben und im Bereich von 0 bis 100 % ihrer Leuchtleistung einstellbar ist.

## Patentansprüche

1. Vorbelichtungseinrichtung für bildmäßig zu belichtende Druckformen mit einem nach unten hin durch eine Scheibe abgeschlossenen Gehäuse, in dem eine Strahlungsquelle angeordnet ist, dadurch gekennzeichnet, daß die Strahlungsquelle eine LED-Zeilenanordnung (8) aus zumindest zwei Reihen von Modulen (Di, Di') aus Leuchtdioden ist, daß die LED-Zeilenanordnung (8) die unterhalb der Vorbelichtungseinrichtung (2) vorbeibewegten Druckformen (4) ganzflächig vorbelichtet, daß die Scheibe eine die LED-Zeilenanordnung (8) nach unten hin abdeckende Lichtstreuscheibe (6) ist und daß die LED-Zeilenanordnung (8) in einem Leuchtstärke- bzw. Leuchtleistungsbereich von 0 bis 100 % regelbar ist.

2. Vorbelichtungseinrichtung nach Anspruch 1, dadurch gekennzeichnet, daß die LED-Zeilenanordnung (8) eine Strahlung für die Vorbelichtung der Druckformen im Wellenlängenbereich von 565 ± 20 nm abstrahlt.

3. Vorbelichtungseinrichtung nach Anspruch 1, dadurch gekennzeichnet, daß die LED-Zeilenanordnung (8) aus zueinander versetzten Reihen von LED-Modulen (Dᵢ; Dᵢ') besteht und daß das einzelne Modul (Dᵢ; Dᵢ') aus mehreren Leuchtdioden zusammengesetzt ist.

4. Vorbelichtungseinrichtung nach Anspruch 3, dadurch gekennzeichnet, daß das einzelne Modul vier Leuchtdioden LED enthält, die in Reihe geschaltet sind.

5. Vorbelichtungseinrichtung nach Anspruch 3, dadurch gekennzeichnet, daß jeweils zwei Module (D₁, D₁'; D₂, D₂'; ... Dₙ, Dₙ') in Reihe geschaltet sind und von einem Stromkreis aus je einem Transistor (T₁; T₂; ... Tₙ), regelbaren oder festen Widerstand (R₁; R₂; ... Rₙ) und einer gemeinsamen Stromquelle für alle Module, die eine Referenzspannung U_{ref} an die Basis der Transistoren liefert, gesteuert sind.

6. Vorbelichtungseinrichtung nach Anspruch 5, dadurch gekennzeichnet, daß die Basen aller Transistoren (T₁, T₂, ... Tₙ) parallel und alle Widerstände (R₁, R₂, ... Rₙ) zwischen den Emittern der Transistoren und einer Masse-Leitung parallel geschaltet sind.

7. Vorbelichtungseinrichtung nach Anspruch 5, dadurch gekennzeichnet, daß die Referenzspannung U_{ref} eine Gleich- oder eine Rechteckspannung mit einem Tastverhältnis 1:2 ist.

8. Vorbelichtungseinrichtung nach Anspruch 1, dadurch gekennzeichnet, daß ein Sensor (3) zur Messung der Leuchtstärke der LED-Zeilenanordnung (8) in der Vorbelichtungseinrichtung (2) vorhanden ist.

9. Vorbelichtungseinrichtung nach Anspruch 3, dadurch gekennzeichnet, daß die LED-Zeilenanordnung (8) aus einzelnen Segmenten (11) besteht, die mittels Steckkontakten (12) zu einer Platine (9) zusammengesteckt sind.

10. Vorbelichtungseinrichtung nach Anspruch 9, dadurch gekennzeichnet, daß die Segmente (11) unterschiedliche oder gleiche Längen aufweisen.

11. Vorbelichtungseinrichtung nach Anspruch 8 oder 9, dadurch gekennzeichnet, daß im Inneren des Gehäuses (1) als Sensor (3) eine Fotodiode auf der Platine (9) angeordnet ist.

## Claims

1. Pre-exposure device for printing members to be exposed with an image, comprising a housing closed at the bottom by a plate, in which housing there is arranged a radiation source, characterised in that the radiation source is an LED array (8) consisting of at least two rows of modules (Di, Di') of light-emitting diodes, in that the LED array (8) pre-exposes the entire surface of the printing members (4) displaced below the pre-exposure device (2), in that the plate is a light-scattering plate (6) covering the LED array (8) at the bottom and in that the luminosity or luminous output of the LED array (8) is controllable between 0 and 100 %.

2. Pre-exposure device according to claim 1,
characterised in that the LED array (8) emits radiation for pre-exposure of the printing members in the wavelength range of 565 ± 20 nm.

3. Pre-exposure device according to claim 1,
characterised in that the LED array (8) comprises staggered rows of LED modules (Dᵢ; Dᵢ') and in that an individual module (Dᵢ; Dᵢ') is composed of several light-emitting diodes.

4. Pre-exposure device according to claim 3,
characterised in that an individual module contains four light-emitting diodes LED connected in series.

5. Pre-exposure device according to claim 3,
characterised in that in each case two modules (D₁, D₁'; D₂, D₂'; ... Dₙ, Dₙ') are connected in series and are controlled by a circuit comprising a transistor (T₁; T₂; ... Tₙ), a variable or fixed resistor (R₁; R₂; ... Rₙ) and a common current source for all the modules which supplies a reference voltage U_{ref} to the bases of the transistors.

6. Pre-exposure device according to claim 5,
characterised in that the bases of the all the transistors (T₁, T₂, ... Tₙ) are connected in parallel and all the resistors (R₁, R₂, ... Rₙ) are connected in parallel between the emitters of the transistors and an earth lead.

7. Pre-exposure device according to claim 5,
characterised in that the reference voltage U_{ref} is a d.c. voltage or a square-wave voltage with a mark-space ratio of 1:2.

8. Pre-exposure device according to claim 1,
characterised in that a sensor (3) is provided in the pre-exposure device (2) to measure the luminosity of the LED array (8).

9. Pre-exposure device according to claim 3,
characterised in that the LED array (8) consists of individual segments (11) which are plugged together by means of plug contacts (12) to form a board (9).

10. Pre-exposure device according to claim 9,
characterised in that the segments (11) are of different or the same lengths.

11. Pre-exposure device according to claim 8 or claim 9, characterised in that a sensor in the form of a photodiode is arranged inside the housing (1) on the board (9).

## Revendications

1. Dispositif de préexposition pour formes d'impression qui doivent être exposées selon une image, comportant un boîtier fermé vers le bas par une vitre dans lequel est disposée une source de rayonnement, caractérisé en ce que la source de rayonnement est un agencement de lignes de LED (8) consistant en au moins deux rangées de modules (Dᵢ, D'ᵢ) de diodes électroluminescentes, en ce que l'agencement de lignes de LED (8) préexpose sur toute la surface les formes d'impression (4) qui sont déplacées sous le dispositif de préexposition (2), en ce que la vitre est une vitre de dispersion de la lumière (6) qui recouvre vers le bas l'agencement de lignes de LED (8) et en ce que l'agencement de lignes de LED (8) est réglable dans un domaine de luminosité ou de puissance d'éclairement de 0 à 100%.

2. Dispositif de préexposition selon la revendication 1 caractérisé en ce que l'agencement de lignes de LED (8) émet un rayonnement dans le domaine de longueur d'onde de 565 ± 20 nm pour la préexposition des plaques d'impression.

3. Dispositif de préexposition selon la revendication 1 caractérisé en ce que l'agencement de lignes de LED (8) consiste en rangées décalées les unes par rapport aux autres de modules de LED (Dᵢ ; D'ᵢ) et en ce que le module individuel (Dᵢ; D'ᵢ) est composé de plusieurs diodes électroluminescentes.

4. Dispositif de préexposition selon la revendication 3 caractérisé en ce que le module individuel contient 4 diodes électroluminescentes LED qui sont branchées en série.

5. Dispositif de préexposition selon la revendication 3 caractérisé en ce que, dans chaque cas, deux modules (D₁, D'₁ ; D₂, D'₂ ; ...Dₙ, D'ₙ) sont branchés en série et sont commandés par un circuit consistant en un transistor (T₁ ; T₂ ; ...Tₙ), en une résistance réglable ou fixe (R₁ ; R₂ ; ...Rₙ) et en une source de courant commune pour tous les modules, qui délivre une tension de référence U_{ref} à la base des transistors.

6. Dispositif de préexposition selon la revendication 5 caractérisé en ce que les bases de tous les transistors (T₁, T₂, ...Tₙ) sont branchées en parallèle et toutes les résistances (R₁, R₂, ...Rₙ) sont branchées en parallèle entre les émetteurs des transistors et un conducteur de masse.

7. Dispositif de préexposition selon la revendication 5 caractérisé en ce que la tension de référence U_{ref} est une tension continue ou rectangulaire avec un rapport de durées de 1:2.

8. Dispositif de préexposition selon la revendication 1 caractérisé en ce qu'un capteur (3) pour la mesure de la luminosité de l'agencement de lignes de LED (8) est présent dans le dispositif de préexposition (2).

9. Dispositif de préexposition selon la revendication 3 caractérisé en ce que l'agencement de lignes de LED (8) consiste en segments individuels (11) qui sont enfichés ensemble en une platine (9) au moyen de contacts à fiches (12).

10. Dispositif de préexposition selon la revendication 9 caractérisé en ce que les segments (11) présentent des longueurs différentes ou identiques.

11. Dispositif de préexposition selon la revendication 8 ou 9 caractérisé en ce qu'une photodiode est disposée sur la platine (9) comme capteur (3) à l'intérieur du boîtier (1).
